# EUROPÄISCHE PATENTANMELDUNG

(11) **EP 3 624 273 A1**
(43) Veröffentlichungstag der Anmeldung: **18.03.2020**
(21) Anmeldenummer: 19194296.0
(22) Anmeldetag: 29.08.2019
(51) Int. Cl.: H01R 13/08, H01R 13/53, H01R 101/00, H01R 13/635, G01R 1/067

(54) **KONTAKTSTIFT MIT KONTAKTMITTEL**

(30) Priorität: 13.09.2018 DE 102018122418; 13.09.2018 DE 202018105251 U
(71) Anmelder: Ingun Prüfmittelbau GmbH, 78467 Konstanz (DE)
(72) Erfinder: STUHLDREIER-KAUFMANN, David, 78467 Konstanz (DE)
(74) Vertreter: Patentanwälte Behrmann Wagner PartG mbB

(57) **Zusammenfassung**

Die Erfindung betrifft einen Kontaktstift (1) zum Kontaktieren eines elektrisch leitenden Bereichs (3) eines Kontaktpartners (2), mit einem Gehäuseelement (10), einem Führungskörper (20), welcher in Längsrichtung des Gehäuseelements (10) beweglich angeordnet und von einem Federelement (40) in Längsrichtung kraftbeaufschlagt ist, und einem als Leiter wirkenden Kontaktelement (30), welches mit dem Führungskörper (20) gegenüber dem Gehäuseelement (10) beweglich ist, so dass es wahlweise zwischen einer eingezogenen Grundstellung (GST) und einer ausgezogenen Dekontaktierungsstellung (DST) verstellbar ist, wobei das Federelement (40) das Kontaktelement (30) in die Grundstellung (GST) vorspannt und derart ausgebildet ist, dass eine Dekontaktierung des Kontaktelements (30) von dem leitenden Bereich (3) des Kontaktpartners (2) mittels federbewirkter Beschleunigung gegenüber dem Gehäuseelement (10) erfolgt, wobei der Kontaktstift (1) ein Kontaktmittel (60, 80) zur Herstellung eines elektrisch leitenden Kontaktes zwischen dem Gehäuseelement (10) und dem Führungskörper (20) und/oder dem Kontaktelement (30) zumindest in der Dekontaktierungsstellung (DST) umfasst, wobei das Kontaktmittel (60, 80) zumindest einen federnd ausgebildeten Federabschnitt aufweist, welcher in Dekontaktierungsstellung (DST) kraftbeaufschlagt an dem Gehäuseelement (10) oder dem Führungskörper (20) anliegt.

## Beschreibung

Die Erfindung betrifft einen Kontaktstift zum Kontaktieren eines elektrisch leitenden Bereichs eines Kontaktpartners und ein System, umfassend einen Kontaktstift.

Derartige Kontaktstifte sind aus der Praxis bekannt und dienen zum lösbaren Kontaktieren eines einen Innenkontakt aufweisenden Kontaktpartners, der als Kuppler ausgebildet sein kann. Solche Verbindungen können dem Leiten von hohem Niederspannungs-Gleichstrom dienen.

Bei Dekontaktierung zwischen dem Kontaktstift und dem Kontaktpartner entsteht zumeist ein ungewollter Spannungsüberschlag, welcher zu einem Störlichtbogen führen kann. Ein derartiger Lichtbogen senkt jedoch die Lebensdauer des Kontaktstiftes und des Kontaktpartners erheblich und kann zu einem schnelleren Defekt der Bauteile führen, beispielsweise durch Abbrand entsprechender Bauteile.

Aufgabe der Erfindung ist es daher, einen Kontaktstift zum Kontaktieren eines elektrisch leitenden Bereichs eines Kontaktpartners zu schaffen, welcher bei anliegender Spannung oder Restspannung die Entstehung eines Störlichtbogens bei der Dekontaktierung möglichst vermeidet und eine verbesserte elektrische Leitfähigkeit aufweist.

Diese Aufgabe wird erfindungsgemäß durch den Kontaktstift mit den Merkmalen des Patentanspruchs 1 gelöst, wonach dieser ein Gehäuseelement, einen Führungskörper, welcher in Längsrichtung des Gehäuseelements beweglich angeordnet und von einem Federelement in Längsrichtung kraftbeaufschlagt ist, und einen als Leiter wirkendes Kontaktelement umfasst. Das Kontaktelement ist mit dem Führungskörper gegenüber dem Gehäuseelement beweglich ausgebildet, sodass es wahlweise zwischen einer eingezogenen Grundstellung und einer ausgezogenen Dekontaktierungsstellung verstellbar ist. Das Federelement spannt das Kontaktierungselement in die Grundstellung vor und ist derart ausgebildet, dass eine Dekontaktierung des Kontaktelements von dem leitenden Bereich des Kontaktpartners mittels federbewirkter Beschleunigung gegenüber dem Gehäuseelement erfolgt. Der Kontaktstift umfasst zudem ein Kontaktmittel zur Herstellung eines elektrisch leitenden Kontaktes zwischen dem Gehäuseelement und dem Führungskörper und/oder dem Kontaktelement zumindest in der Dekontaktierungsstellung, wobei das Kontaktmittel zumindest einen federnd ausgebildeten Federabschnitt aufweist, welcher in Dekontaktierungsstellung kraftbeaufschlagt an dem Gehäuseelement oder dem Führungskörper anliegt.

Der erfindungsgemäße Kontaktstift steigert im erheblichen Maße die Geschwindigkeit, mit welcher sich das Kontaktelement von dem leitenden Bereich des Kontaktpartners entfernt, um so in sehr kurzer Zeit eine als Sicherheitsabstand zum Kontaktpartner dienende Strecke zurückzulegen, welche die Entstehung eines Lichtbogens ausschließt oder zumindest die Einwirkzeit eines Lichtbogens minimal hält.

Ein Kontakt zwischen dem Kontaktelement und dem Kontaktpartner kann beispielsweise mittels Klemmkontakt erfolgen, wobei hierbei der Kontaktstift als Steckerelement und der Kontaktpartner als Kupplerelement dienen kann. In Kontaktstellung zwischen dem Kontaktelement und dem Kontaktpartner ist das Kontaktelement in seine eingezogene Grundstellung verstellbar. In dieser Grundstellung weist das Federelement das geringste Energieniveau auf, bzw. ist größtmöglich entspannt. In Grundstellung kann zudem das Kontaktelement an dem Gehäuseelement anliegen. Somit ist der Kontaktstift von Strom durchfließbar.

Eine Dekontaktierung verläuft nun in zumindest zwei Schritten. In einem ersten Dekontaktierungsschritt kann nun eine in Längsrichtung des Gehäuseelements wirkende Kraft auf das Gehäuseelement aufgebracht werden, welche von dem Kontaktpartner weg weist. Diese Zugkraft führt dazu, dass sich das Gehäuseelement von dem Kontaktpartner entfernt, das Kontaktelement jedoch aufgrund einer Kontaktkraft, wie beispielsweise einer Klemmkraft, und der Federlagerung in Kontakt mit dem Kontaktpartner verbleibt. Somit wird das Gehäuseelement um eine definierte Länge gegenüber dem Kontaktelement bei weiterhin bestehendem Kontakt verstellt. Hierbei kann die Länge so gewählt werden, dass der Abstand ausreicht, um die Entstehung eines Störlichtbogens auszuschließen oder zumindest die Einwirkzeit eines Störlichtbogens zu reduzieren. Die Dekontaktierungsstellung ist durch diejenige Stellung definiert, in welcher die Haltekraft zwischen dem Kontaktstift und dem Kontaktpartner minimal größer ist als die durch das Federelement des Kontaktstifts aufgebrachte Federkraft. Der zweite Dekontaktierungsschritt beginnt, wenn die auf das Gehäuseelement aufgebrachte Zugkraft bzw. die auf das Kontaktelement aufgebrachte Federkraft die Haltekraft des Kontaktpartners übersteigt. Dann löst sich das Kontaktelement von dem leitenden Bereich des Kontaktpartners und wird schlagartig und federbewirkt in Richtung des Gehäuseelements eingezogen. Somit ist eine federbewirkte Beschleunigung des Kontaktelements gegenüber dem Gehäuseelement realisiert.

Die Ausbildung des Federelements kann beispielsweise auf der Werkstoffwahl, dem Drahtdurchmesser, dem Windungsdurchmesser, der Länge, der Federkraft und/oder beispielsweise der Federkonstante beruhen.

Der wesentliche Vorteil des erfindungsgemäßen Kontaktstiftes kann insbesondere darin gesehen werden, dass der zumindest eine federnd ausgebildete Federabschnitt des Kontaktmittels zu einem kraftbeaufschlagen und somit verstärkbaren elektrischen Kontakt führt. Die Verstärkbarkeit des elektrischen Kontakt führt dazu, dass eine größere Reibung und/oder ein größerer Anpressdruck zwischen dem Kontaktmittel und dem von diesem kontaktieren Element entsteht und somit gleichsam eine elektrische Widerstandsreduktion und eine verbesserte Leitfähigkeit realisiert ist.

Das Kontaktmittel kann daher gleichzeitig sowohl als Schutz gegen Verkippen oder Verkanten des Führungskörpers und/oder des Kontaktelements dienen als auch einen sicheren elektrischen Kontakt oder Schleifkontakt zwischen dem Führungskörper und/oder dem Kontaktelement und dem Gehäuseelement realisieren. Es besteht daher immer ein sicherer elektrischer Übergang und es kann zu keinem Abbrand/Überschlag zwischen Kontaktelement und/oder Führungselement und Gehäuseelement kommen - auch in der Bewegung.

Ein weiterer Vorteil des erfindungsgemäßen Kontaktstiftes kann insbesondere darin gesehen werden, dass ein Lichtbogen gar nicht erst entsteht oder ein Abriss des Lichtbogens nach sehr kurzer Zeit erfolgt, sodass die Einwirkdauer des schädlichen Lichtbogens sehr kurz ist. Die federbewirkte Beschleunigung führt zu einem schnellen Trennen der beiden Kontaktpartner und einem schnellen Erreichen eines ausreichenden Abstandes zwischen dem Kontaktpartner und dem Kontaktstift, bei welchem kein Lichtbogen entstehen kann. Somit kann der Kontaktstift selbst bei vorliegender Restladung abgezogen werden.

Bei einer bevorzugten Ausführungsform des Kontaktstiftes nach der Erfindung ist das Kontaktmittel in einem zwischen dem Gehäuseelement und dem Führungskörper und/oder dem Kontaktelement gebildeten Zwischenraum angeordnet und/oder zumindest abschnittsweise hülsenartig ausgebildet. Das Kontaktmittel ist somit als elektrisches Leitmittel zwischen dem in Dekontaktierungsstellung bezogen auf den Kontaktpartner unbewegten Kontaktelement und dem in Dekontaktierungsstellung bezogen auf den Kontaktpartner bewegten bzw. bewegbaren Gehäuselement angeordnet, um eine verbesserte Leitfähigkeit und ein verbessertes Ableiten von Strömen zu ermöglichen. Das Kontaktmitteln kann folglich von dem Führungskörper und/oder dem Kontaktelement durchgriffen sein, wobei insbesondere dort ein elektrisch leitender Kontakt ausgebildet ist. Hierbei kann von Vorteil sein, wenn das Kontaktmittel verschiebbar gegenüber dem Führungskörper und/oder dem Kontaktelement gelagert ist.

Es ist gemäß einer weiteren bevorzugten Ausführungsform des Kontaktstiftes nach der Erfindung denkbar, dass die Kraftbeaufschlagung in Längsrichtung des Gehäuseelements und/oder ausschließlich durch das Federelement erfolgt. Dadurch, dass die räumliche Erstreckung des Kontaktstiftes in dessen Längsrichtung erheblich größer als in dessen Querrichtung ist, eignet sich zur Einhaltung kleiner Bauräume eine Kraftbeaufschlagungsrichtung, die mit der räumliche Erstreckung des Gehäuseelements korrespondiert. Da das Federelement in dieser Richtung angeordnet ist und eine Kraft aufbringen kann, kann das Federelement nicht nur zur Vorspannung des Kontaktelements in die Grundstellung dienen sondern auch zur Kraftbeaufschlagung des Kontaktmittels. Aufgrund der Doppelfunktion des Federelements ist die Anzahl benötigter Einzelteile gering und ein kleiner benötigter Bauraum realisiert.

Gemäß einer weiteren bevorzugten Ausführungsform des Kontaktstiftes nach der Erfindung ist vorgesehen, dass der Federabschnitt gebildet ist von einer Klemmlasche, wobei das Kontaktmittel vorzugsweise mehrere, weiter bevorzugt acht, zueinander beabstandete und in Längsrichtung des Gehäuseelements verlaufende Klemmlaschen aufweist. Die Klemmlaschen können identisch ausgebildet und/oder gleichmäßig beabstandet sein. Auch diese Klemmlaschen sowie deren Anordnung tragen dem geringen Bauraum Rechnung. Benachbarte Klemmlaschen können beispielsweise durch einen dazwischen angeordneten Spalt voneinander getrennt sein. Die Federabschnitte können ihre Federfunktion beispielsweise aufgrund geeigneter Materialauswahl und/oder konstruktiver Ausgestaltung erhalten.

Bei einer weiteren bevorzugten Ausführungsform des Kontaktstiftes nach der Erfindung umfasst der Kontaktstift ein Spannmittel, welches derart ausgebildet ist, dass mit zunehmendem Auszug des Führungskörpers gegenüber dem Gehäuseelement die Kraftbeaufschlagung auf den Federabschnitt steigt. Dadurch steigt gleichsam der Anpressdruck zwischen dem Federabschnitt und des daran anliegenden Elements, wie beispielsweise des Gehäuseelements oder des Führungskörpers oder des Kontaktelements. Die steigende Kraftbeaufschlagung in Richtung Dekontaktierung bzw. die Verstärkung des elektrischen Kontakts führt dazu, dass eine größere Reibung und/oder ein größerer Anpressdruck entstehen und somit gleichsam eine elektrische Widerstandsreduktion und eine verbesserte Leitfähigkeit realisiert sind. Gerade diese Ausführung dient der Steigerung der Sicherheit, da in Dekontaktierungsstellung bzw. zu einem Zeitpunkt unmittelbar vor Dekontaktierung (Dekontaktierungsstellung) die Reibung und/oder der Anpressdruck groß und die Leitfähigkeit ebenfalls groß ist.

Es ist weiterbildungsgemäß denkbar, dass das Spannmittel gebildet ist von einer Stützrampe an dem Gehäuseelement oder an dem Führungskörper, auf welche bei Auszug des Führungskörpers und/oder des Kontaktelements gegenüber dem Gehäuseelement das Kontaktmittel auflaufen kann und/oder gebildet ist von zumindest einem zu dem Gehäuseelement und/oder zu dem Führungskörper und/oder zu dem Kontaktelement gewölbten Spannabschnitt des Kontaktmittels und/oder gebildet ist von einem in Längsrichtung des Gehäuseelements zumindest abschnittsweise konisch ausgebildeten Führungskörper und/oder Kontaktelement. Bei dem Spannmittel in seiner ersten Ausführungsform ist es als Stützrampe an dem Gehäuseelement ausgebildet. Der Führungskörper oder dessen Federabschnitt kann bei Auszug des Führungskörpers auf die Stützrampe auflaufen, wobei hierfür der Führungskörper oder dessen Federabschnitt eine Auflaufschräge umfassen kann, deren Oberfläche parallel zu der entsprechenden Oberfläche der Stützrampe verlaufen kann. Die Stützrampe ist so angeordnet, dass sie bei Auszug den Führungskörper aufweitet oder dessen Federabschnitt nach radial außen oder innen verlagert. Das Kontaktmittel und das Spannmittel können hierbei in Grundstellung in dem dem Kontaktelement gegenüberliegenden Endbereich des Kontaktstiftes oder des Führungskörpers angeordnet sein. Bei dem Spannmittel in seiner zweiten Ausführungsform ist es als Stützrampe an dem Führungskörper ausgebildet, wobei in diesem Fall die Funktion der ersten Ausführungsform ähnelt. Das Kontaktmittel und das Spannmittel können hierbei jedoch in Grundstellung in dem dem Kontaktelement zugewandten Endbereich des Kontaktstiftes oder des Führungskörpers angeordnet sein. Bei dem Spannmittel in seiner dritten Ausführungsform ist es als zumindest ein zu dem Gehäuseelement und/oder zu dem Führungskörper und/oder zu dem Kontaktelement gewölbter Spannabschnitt des Kontaktmittels ausgebildet. In einen derartigen Spannabschnitt ist in einfacher Weise eine Kraft eintragbar, die aufgrund der Wölbung orthogonal zu der Richtung der Eintragungskraft weitergeleitet werden kann. Dadurch kann eine Anpressdrucksteigerung bei gleichzeitig geringer Bauraumnutzung realisiert werden. Bei dem Spannmittel in seiner vierten Ausführungsform ist es als ein konischer Verlauf in Längsrichtung des Gehäuseelements das Führungskörpers und/oder Kontaktelements ausgebildet. Vorzugsweise nimmt der Querschnitt mit zunehmender Entfernung von dem Kontaktelement zu. Dies führt dazu, dass mit zunehmendem Auszug des Führungskörpers und/oder Kontaktelements die Kraftbeaufschlagung auf den Federabschnitt steigt und zwar dadurch, dass der Federabschnitt zunehmend gegenüber seiner Ruhestellung verlagert und an das entsprechend kontaktierte Element angepresst wird.

Es ist gemäß einer weiteren bevorzugten Ausführungsform des Kontaktstifts nach der Erfindung denkbar, dass das Gehäuseelement einen zumindest abschnittsweise umfangsseitig angeordneten Einschnürungsabschnitt aufweist, welcher derart mit dem Kontaktmittel zusammenwirkt, dass er zumindest in der Dekontaktierungsstellung eine Bewegungsrichtung des Federabschnitts in Richtung zu dem Führungskörper und/oder zu dem Kontaktelement vorgibt. Somit wird der in den Federabschnitt eingetragenen Kraft eine Richtung vorgegeben, wodurch eine gewünschte und anpressdruckerhöhende Verformung und/oder Verlagerung des Federabschnitts erfolgen kann. Ganz besonders geeignet ist die Kombination des Einschnürungsabschnitts und des Spannmittels als gewölbter Spannabschnitt, da somit dem gewölbten Spannabschnitt eine Bewegungsrichtung vorgebbar ist.

Bei einer weiteren bevorzugten Ausführungsform des Kontaktstiftes nach der Erfindung ist zumindest das Kontaktmittel derart ausgebildet, dass die Kraftbeaufschlagung in Dekontaktierungsstellung bezogen auf den Auszugsweg des Führungskörpers und/oder des Kontaktelements gegenüber dem Gehäuseelement maximal ist. Das sorgt dafür, dass in der Phase des Dekontaktierungsvorganges mit dem größten Sicherheitsrisiko ein Kontaktstift mit größter Leitungssicherheit gegenübergestellt wird. Je größer nämlich die Kraftbeaufschlagung und der Anpressdruck sind, desto größer ist auch die Leitungsfähigkeit des Kontaktstiftes.

Es ist denkbar, dass das Kontaktmittel beispielsweise ein schleifend angeordnetes und/oder ausgebildetes Element, beispielsweise eine Ringfeder ist und/oder leitfähiges/metallisches Polymer umfasst und/oder als Ätz-, Biege-, Stanz-, und/oder Frästeil ausgebildet ist.

Bei einem Beispiel des Kontaktstiftes ist das Federelement derart ausgebildet, dass eine Dekontaktierung bei einer Zugkraft von 3,5N bis 6,5N, vorzugsweise zwischen 4,25N und 5,75N, besonderes bevorzugt bei 5N erfolgt. Zusätzlich oder alternativ ist die Feder derart ausbildbar, dass eine Dekontaktierung bei einer Auszugslänge zwischen Kontaktelement und Gehäuseelement von 19,5mm bis 10,5mm, vorzugsweise von 17,25mm bis 12,75mm, besonders bevorzugt von 15mm erfolgt. Dadurch ist ein Kontaktstift ausbildbar, welcher zunächst eine ausreichende Auszugslänge ausbildet und erst dann eine Dekontaktierung zulässt.

Es hat sich zudem gezeigt, dass das Gehäuseelement an seinem dem Kontaktelement zugewandten axialen Ende einen Stützflansch zur oberen Abstützung des Federelements aufweisen kann.

Bei einem weiteren Beispiel des Kontaktstiftes ist das Kontaktelement mit dem Führungskörper verschraubt und/oder verklemmt. Dadurch muss lediglich das Kontaktelement getauscht werden, um den Kontaktstift an die Anforderungen einer Anwendung anzupassen. Zudem kann ein verbrauchtes oder defektes Kontaktelement in einfacher Weise ausgetauscht werden, was zu einer längeren Lebensdauer des Kontaktstiftes führt, da die übrigen Bauteile weiterverwendbar sind.

Um eine hohe Praxissicherheit zu gewährleisten, hat sich die Verwendung einer Ausnehmung für einen isolierenden Berührungsschutz als vorteilhaft erwiesen.

Erfindungsgemäß wird zudem ein System vorgeschlagen, umfassend zumindest einen in einem Stecker angeordneten erfindungsgemäßen Kontaktstift und einen Gegenstecker mit zumindest einem Kontaktpartner zum elektrischen Kontaktierung mit dem Kontaktstift.

Das erfindungsgemäße System weist im Wesentlichen die Vorteile des Kontaktstiftes auf, worauf hiermit verwiesen wird.

Es ist zudem ein Verfahren zur Dekontaktierung eines Kontaktstifts von einem elektrisch leitenden Bereich eines Kontaktpartners offenbart, umfassend
- Kraftbeaufschlagen eines Gehäuseelements des Kontaktstifts in Längsrichtung des Gehäuseelements und entgegengesetzter Richtung zu dem Kontaktpartner,
- dadurch Steigern einer Anpresskraft zwischen einem Kontaktelement und dem Gehäuseelement und einem Führungskörper und/oder einem Kontaktelement zur Herstellung oder Aufrechterhaltung einer elektrisch leitenden Verbindung,
- Erreichen einer Dekontaktierungsstellung, in welcher die Haltekraft zwischen dem Kontaktstift und dem Kontaktpartner minimal größer ist als die durch ein Federelement des Kontaktstifts aufgebrachte Federkraft zum Lösen der Verbindung,
- weiteres Kraftbeaufschlagen des Gehäuseelements zum Überwinden der Haltekraft,
- Einziehen des Kontaktelements in das Gehäuseelement mittels durch die Feder aufgebrachter Federkraft.

Das erfindungsgemäße Verfahren weist im Wesentlichen die Vorteile des Kontaktstiftes auf, worauf hiermit verwiesen wird.

Zur Vermeidung von Wiederholungen sollen vorrichtungsgemäß offenbarte Merkmale auch als verfahrensgemäß offenbart gelten und beanspruchbar sein. Ebenso sollen verfahrensgemäß offenbarte Merkmale auch als vorrichtungsgemäß offenbart gelten und beanspruchbar sein.

Weitere Vorteile, Merkmale und Einzelheiten der Erfindung ergeben sich aus den Unteransprüchen und zudem aus der nachfolgenden Beschreibung bevorzugter Ausführungsbeispiele sowie anhand der Zeichnung.

Diese zeigt in:
- Fig. 1: eine schematische Ansicht eines erfindungsgemäßen Kontaktstifts in Grundstellung,
- Fig. 2: einen Längsschnitt durch den Kontaktstift nach Fig. 1 entlang der Linie II-II,
- Fig. 3: eine schematische Ansicht des erfindungsgemäßen Kontaktstiftes nach Fig. 1 in Dekontaktierungsstellung,
- Fig. 4: einen Längsschnitt durch den Kontaktstift nach Fig. 3 entlang der Linie IV-IV,
- Fig. 5: eine schematische Ansicht eines erfindungsgemäßen Kontaktstifts gemäß einer weiteren Ausführungsform in Grundstellung,
- Fig. 6: einen Längsschnitt durch den Kontaktstift nach Fig. 5 entlang der Linie VI-VI,
- Fig. 7: eine schematische Ansicht eines erfindungsgemäßen Kontaktstifts gemäß einer weiteren Ausführungsform in Grundstellung,
- Fig. 8: einen Längsschnitt durch den Kontaktstift nach Fig. 7 entlang der Linie VIII-VIII,
- Fig. 9: eine Detailansicht des Kontaktstiftes nach Fig. 2, und
- Fig. 10: eine perspektivische Einzelansicht eines Kontaktmittels gemäß einer ersten Ausführungsform.

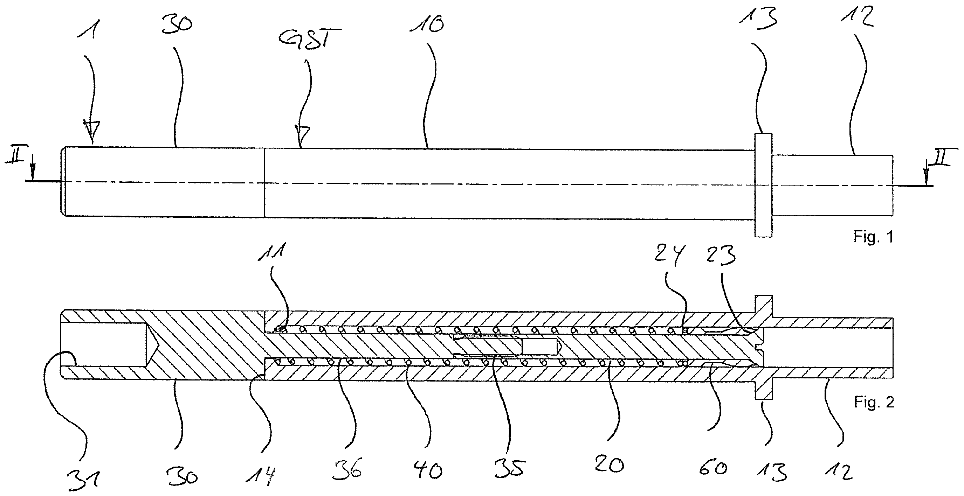

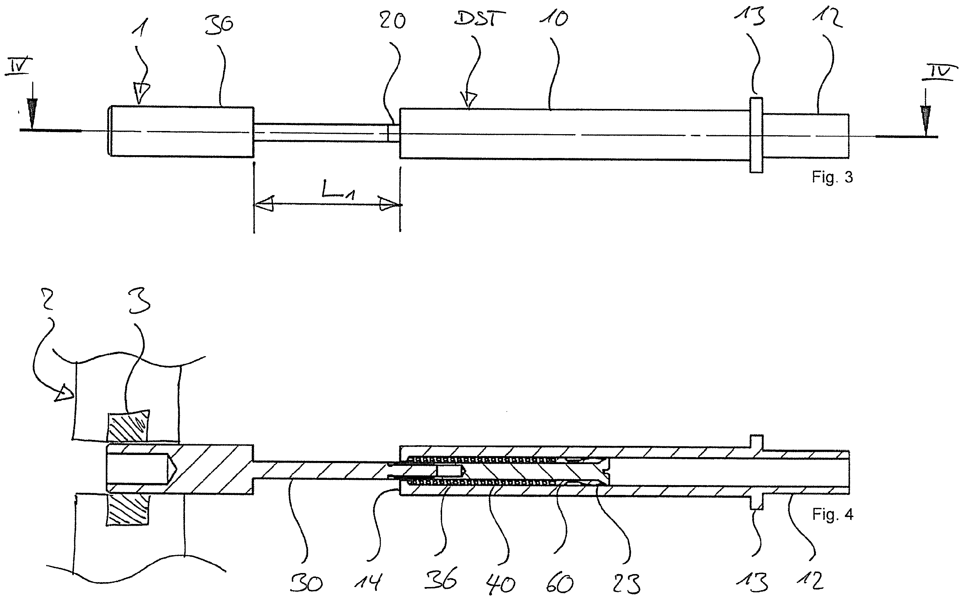

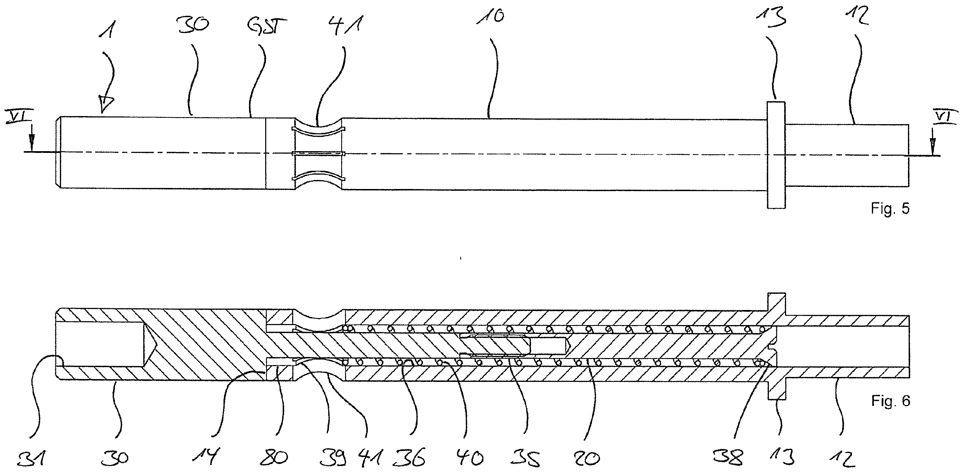

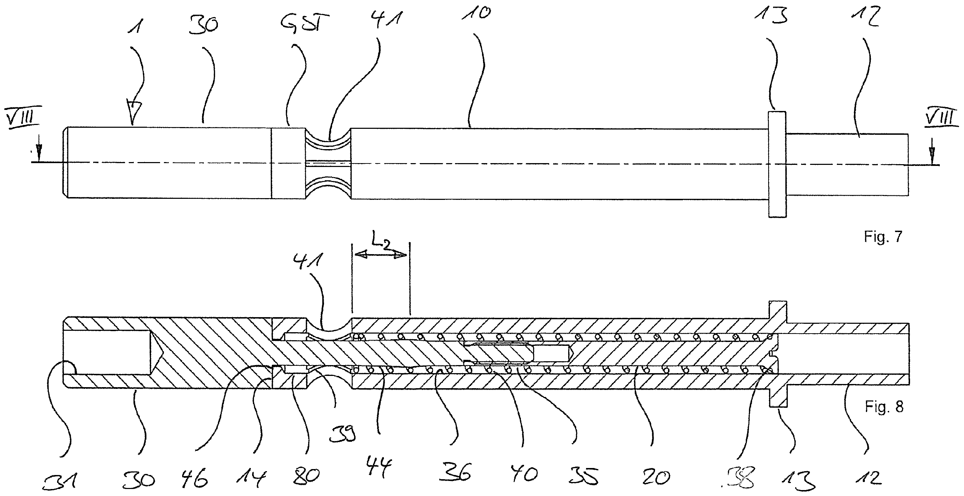

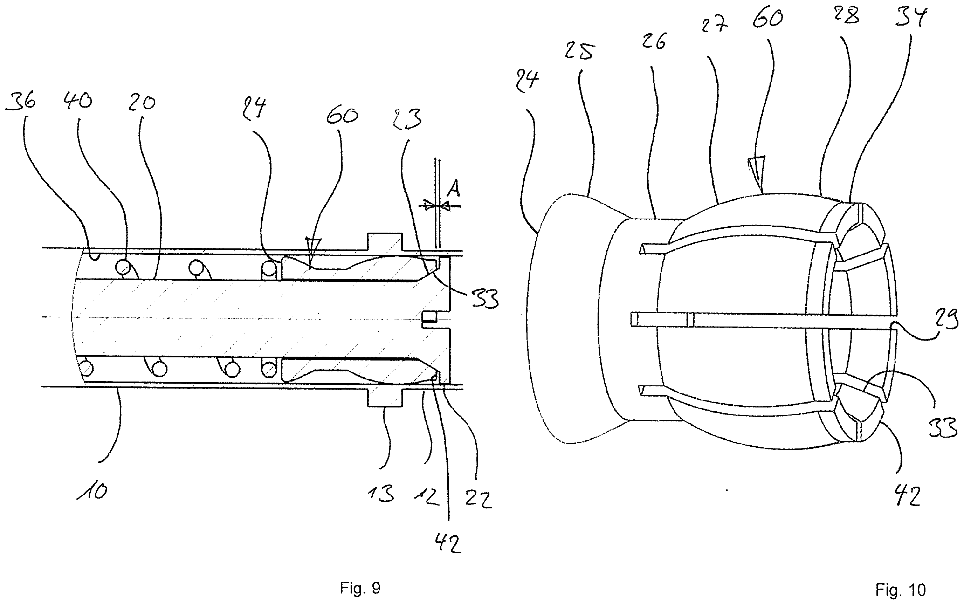

Die Figuren 1 bis 8 zeigen jeweils einen Kontaktstift 1 zum klemmenden Kontaktieren eines elektrisch leitenden Bereichs 3 eines Kontaktpartners 2, dargestellt in Figur 4. Die Figuren 1 bis 4 sind gerichtet auf einen Kontaktstift 1, umfassend ein Kontaktmittel 60 gemäß einer ersten Ausführungsform. Die Figuren 5 und 6 zeigen einen Kontaktstift 1, umfassend ein Kontaktmittel 80 gemäß einer zweiten Ausführungsform. Die Figuren 7 und 8 bilden einen weiteren Kontaktstift 1 ab, umfassend das Kontaktmittel 80. Die Figuren 9 und 10 zeigen das Kontaktmittel 60 gemäß der ersten Ausführungsform in detaillierter Ansicht.

Die Figuren 1 und 2 zeigen dabei den Kontaktstift 1 in einer Grundstellung bzw. einer Stellung vor einer entsprechenden Kontaktierung bzw. nach einer Dekontaktierung. Die Figuren 3 und 4 zeigen den Kontaktstift 1 in einer Dekontaktierungsstellung bzw. in einer Stellung, in welcher die Dekontaktierung unmittelbar bevorsteht.

Der Kontaktstift 1 umfasst ein vorzugsweise hülsenförmiges Gehäuseelement 10, in welchem in Längsrichtung des Gehäuseelements 10 ein Führungskörper 20 beweglich angeordnet ist. Mit dem Führungskörper 20 ist ein Kontaktelement 30 über eine Verschraubung 35 verschraubt, welches mit dem Führungskörper 20 gegenüber dem Gehäuseelement 10 beweglich ist. Zwischen dem Führungskörper 20 und dem Kontaktelement 30 ist innerhalb des Gehäuseelements 10 ein Zwischenraum 36 ausgebildet. Das Kontaktelement 30 wirkt als Leiter und ist wahlweise zwischen einer in den Fig. 1 und 2 dargestellten eingezogenen Grundstellung GST und einer in den Fig. 3 und 4 dargestellten ausgezogenen Dekontaktierungsstellung DST verstellbar. In Grundstellung GST liegt das Kontaktelement 30 an einem endseitigen Anschlagsbereich 14 des Gehäuseelements 10 an. Das Kontaktelement 30 weist eine Ausnehmung 31 auf, in welcher ein in Figur 3 gezeigter isolierender Berührungsschutz 37 einbringbar ist.

Wie Fig. 2 zeigt, weist das Gehäuseelement 10 an seinem dem Kontaktelement 30 zugewandten axialen Ende einen Stützflansch 11 auf, welcher zur oberen Abstützung eines Federelements 40 dient. An dem Führungskörper 20 ist das Kontaktmittel 60 angeordnet, um eine untere Abstützung für das Federelement 40 auszubilden. Das Federelement 40 liegt direkt an einer Stirnfläche 24 des Kontaktmittels 60 an. In der gezeigten Grundstellung GST weist das Federelement 40 das geringste Energieniveau auf, bzw. ist größtmöglich entspannt. Das Kontaktmittel 60 ist in dem dem Kontaktelement 30 gegenüberliegenden Endbereich des Kontaktstiftes 1 bzw. des Führungskörpers 20 verschiebbar gegenüber dem Führungskörpers 20 in einem Zwischenraum 36 angeordnet. Das Kontaktmittel 60 liegt mit einer Auflaufschräge 33 an einer als Spannmittel dienenden Stützrampe 23 des Führungskörpers an, detaillierter dargestellt in den Figuren 9 und 10. Auf die Stützrampe 23 kann bei Auszug des Führungskörpers 20 gegenüber dem Gehäuseelement 10 das Kontaktmittel 60 auflaufen zum Herstellung eines gesteigerten Anpressdrucks. Hierzu dienen mehrere, vorzugsweise acht, federnd ausgebildete Federabschnitte, welche in Dekontaktierungsstellung DST kraftbeaufschlagt an dem Gehäuseelement 10 anliegen. Die Federabschnitte sind gebildet von Klemmlaschen 28. Die Kraftbeaufschlagung in Längsrichtung des Gehäuseelements 10 erfolgt ausschließlich durch das Federelement 40. Es ist erkennbar, dass das Spannmittel bzw. die Stützrampe 23 derart ausgebildet ist, dass mit zunehmendem Auszug des Führungskörpers 20 gegenüber dem Gehäuseelement 10 die Kraftbeaufschlagung auf den Federabschnitt steigt. Insbesondere ist das Kontaktmittel 60 derart ausgebildet, dass die Kraftbeaufschlagung in Dekontaktierungsstellung DST bezogen auf den Auszugsweg des Führungskörpers 20 gegenüber dem Gehäuseelement 10 maximal ist.

In den Fig. 3 und 4 besteht ein elektrischer Kontakt zwischen dem Kontaktelement 30 und dem elektrisch leitenden Bereich 3 des Kontaktpartners 2. Das Kontaktelement 30 ist mittels einer Klemmkraft in bekannter Weise in dem Kontaktpartner 2 gehalten.

Die Rückstellung aus der in den Figuren 3 und 4 gezeigten Dekontaktierungsstellung DST in die Grundstellung GST erfolgt mittels des als Schraubendruckfeder ausgeführten Federelements 40, welches den Führungskörper 20 in Längsrichtung des Gehäuseelements 10 kraftbeaufschlagt. Das Federelement 40 ist im gezeigten Beispiel zwar als schraubenförmige Druckfeder ausgebildet, jedoch ist auch jede andere Federform, wie beispielsweise eine schraubenförmige Zugfeder oder eine schraubenförmige Wellenfeder denkbar.

Das Federelement 40 spannt somit das Kontaktelement 30 in die Grundstellung GST vor. Wie im Folgenden näher erläutert wird, ist das Federelement 40 derart ausgebildet, dass eine Dekontaktierung des Kontaktelements 30 von dem leitenden Bereich 3 des Kontaktpartners 2 mittels federbewirkter Beschleunigung gegenüber dem Gehäuseelement 10 erfolgt.

Das Gehäuseelement 10 weist an seinem dem Kontaktelement 30 axial gegenüberliegenden Ende ein Befestigungselement 12 auf, welches beispielsweise als Lötabschnitt dienen kann. Dadurch sind in vorteilhafter Weise Torsionsbelastungen des Kontaktstifts 1 ausgeschlossen.

Das Gehäuseelement 10 weist zudem einen äußeren Ringflansch 13 auf. Bis auf den Ringflansch 13 weisen das Gehäuseelement 10 und das Kontaktelement 20 eine zylindrische Form und einen identischen Außenradius auf. Somit ist eine homogene und gleichmäßige Außenkontur ausgebildet, welche ein Kontaktieren des Kontaktstiftes 1 mit einem Kontaktpartner 2 wesentlich erleichtert.

Der in den Fig. 1 bis 10 gezeigte Kontaktstift 1 kann eine Länge von 58,5mm aufweisen. Der Durchmesser des Kontaktstiftes 1 kann im Bereich des Ringflansches 13 5mm und im übrigen Bereich 4mm betragen. Die Länge des aus dem Führungskörper 20 in Grundstellung GST herausragenden Teils des Kontaktelements 30 kann 9mm zählen.

Die Figuren 5 und 6 zeigen einen Kontaktstift 1 mit einem Kontaktmittel 80 gemäß einer weiteren Ausführungsform, wobei im Folgenden lediglich auf die Unterschiede zu den Figuren 1 bis 4 eingegangen werden soll. Das Kontaktmittel 80 umfasst mehrere, vorzugsweise sechs, federnd ausgebildete Federabschnitte, welche durch gewölbte Spannabschnitte 39 ausgebildet sind. Diese Spannabschnitte 39 bilden zugleich das Spannmittel aus. Der Kontaktstift 1 umfasst im Bereich der Spannabschnitte 39 einen umfangsseitig durchgehend angeordneten Einschnürungsabschnitt 41, welcher derart mit dem Kontaktmittel 80 zusammenwirkt, dass er zumindest in der Dekontaktierungsstellung DST eine Bewegungsrichtung der Federabschnitte bzw. Spannabschnitte 39 in Richtung zu dem Führungskörper 20 vorgibt. Bei federbewirkter Kraftbeaufschlagung der Spannabschnitte 39 lässt der konkave Einschnürungsabschnitt 41 den Spannabschnitten 39 keinen Raum, um sich von dem Kontaktelement 30 und/oder dem Führungskörpers 20 weg zu biegen bzw. nach radial außen zu biegen. Das Kontaktmittel 80 ist in der gezeigten Grundstellung GST in dem dem Kontaktelement 30 zugewandten Endbereich des Kontaktstiftes 1 oder des Führungskörpers 10 angeordnet. Das Federelement 40 stützt sich einerseits an der Stirnfläche 24 des Kontaktmittels 80 und andererseits an einer Stützfläche 38 des Führungskörpers 20 ab. Bei Auszug des Führungskörpers 20 gegenüber dem Gehäuseelement 10 wird das Federelement 40 komprimiert und drückt auf die Spannabschnitte 39 des Kontaktmittels 80. Aufgrund deren Wölbung in Richtung des Führungskörpers 20 und des Kontaktelements 30 sowie aufgrund des Einschnürungsabschnitts 41 werden die Spannabschnitte 39 nach radial innen verstellt bzw. verbogen und liegen je nach Auszugsweite kraftbeaufschlagt an dem Führungskörper 20 oder dem Kontaktelement 30 an.

Die Figuren 7 und 8 zeigen einen Kontaktstift 1 mit dem aus den Figuren 5 und 6 bekannten Kontaktmittel 80 gemäß einer weiteren Ausführungsform. Im Folgenden soll lediglich auf die Unterschiede zu den Figuren 5 und 6 eingegangen werden. Ein Spannmittel ist gebildet von einem konischen Abschnitt 44 des Kontaktelements 30, wobei der Durchmesser des Abschnitts 44 in Längsrichtung des Kontaktstifts 1 mit zunehmendem Abstand von einem für den leitenden Bereich 3 des Kontaktpartners 2 vorgesehenen Kontaktbereich des Kontaktelements 30 zunimmt. Der Abschnitt 44 erstreckt sich über eine Länge L₂ des Kontaktelements 30. Im Bereich des Anschlagbereichs 14 weist das Gehäuselement 10 einen Kragen 46 auf, welcher das Kontaktmittel 80 in Längsrichtung des Kontaktstifts 1 fixiert. Bei Auszug des Führungskörpers 20 gegenüber dem Gehäuseelement 10 wird das Federelement 40 komprimiert und drückt auf die ggf. bereits vorgespannten Spannabschnitte 39 des Kontaktmittels 80. Aufgrund deren Wölbung in Richtung des Führungskörpers 20 und des Kontaktelements 30 liegen die Spannabschnitte 39 je nach Auszugsweite kraftbeaufschlagt an dem Führungskörper 20 oder dem Kontaktelement 30 an. Innenseitig steht den Spannabschnitten 39 mit zunehmender Auszugslänge der sich dadurch verdickende Querschnitt des Abschnitts 44 entgegen, wodurch eine Kontaktkraft zwischen dem Führungskörper 20 bzw. dem Abschnitt 44 als Spannmittel und dem Kontaktmittel 80 noch weiter gegenüber der Ausführungsform gemäß Figuren 5 und 6 erhöht wird. Mit zunehmendem Auszug des Kontaktelements 30 und des Führungskörpers 20 erfahren die Spannabschnitte 39 aufgrund des sich verdickenden oder konischen Abschnitts 44 eine nach radial außen wirkende Kraft. Die maximale Auszugslänge des Kontaktelements 30 ist in Abhängigkeit des Kontaktpartners 2 so bemessen, dass die Dekontaktierungsstellung DST dann erreicht ist, wenn die Spannabschnitte 39 am größten Durchmesser des Abschnitts 44 anliegen.

Fig. 9 zeigt eine Detailansicht des Kontaktstiftes 1 nach Fig. 2 im Bereich des Kontaktmittels 60. Der Führungskörper 20 weist an seinem axialen dem Kontaktelement 30 gegenüberliegenden Ende einen Stützflansch 22 auf, welcher mittels der Stützrampe 23 in den Kernbereich des Führungskörpers 20 übergeht. Zwischen der Bodenseite 42 des Kontaktmittels 60 und der gegenüberliegenden Oberfläche des Stützflansches 22 ist ein Abstand A ausgebildet, welcher in Grundstellung GST größer Null ist und in Dekontaktierungsstellung DST Null sein kann, jedoch zumindest kleiner ist.

Aus Fig. 10 ist ersichtlich, dass das Kontaktmittel 60 eine dem Kontaktelement 30 zugewandte Stirnfläche 24 aufweist, welche als Abstützfläche für das Federelement 40 dient. Die Stirnfläche 24 ist an einem Kragenbereich 25 des Kontaktmittels 60 angeordnet, welcher in Längsrichtung in einen Einschnürbereich 26 übergeht, an welchen sich in Längsrichtung ein Laschenbereich 27 anschließt. Der Einschnürbereich 26 weist einen kleineren Außendurchmesser auf als der Kragenbereich 25 und der Laschenbereich 27. Der Laschenbereich 27 weist mehrere, vorzugsweise acht, gleichmäßig beabstandete Klemmlaschen 28 auf. Zwischen benachbarten Klemmlaschen 28 ist jeweils ein Spalt 29 ausgebildet, welcher bis in den Einschnürbereich 26 ragt. Jede Klemmlasche 28 weist eine bombierte Außenfläche 32, die mit der Stützrampe 23 korrespondierende innere Einlaufschräge 33 und einen mit dem Stützflansch 22 korrespondierenden Stützfußabschnitt 34 auf.

Das Kontaktmittel 60 dient als Stützelement für das Federelement 40 und hat gleichzeitig die Funktion eines sicheren elektrischen Kontakts oder Schleifkontakts zum Gehäuseelement 10 bzw. zu dessen Innenfläche. Dadurch kann jederzeit ein sicherer elektrischer Übergang bestehen. Somit ist auch ein Abbrand und/oder Überschlag zwischen Kontaktelement 30 bzw. Führungselement 20 und Gehäuseelement 10 in jeder Stellung ausgeschlossen.

Die Klemmlaschen 28 des Kontaktmittels 60 werden bei dem Herausziehen des Führungselements 20 durch das Kraftbeaufschlagen vermittels des Federelements 40 über die Stützrampe 23 und die innere Einlaufschräge 33 nach radial außen gedrückt und dadurch wird der elektrische Kontakt bei dem Herausziehen noch verstärkt über die ansteigende Federkraft des Federelements 40.

Eine Dekontaktierung des Kontaktelements 30 von dem Kontaktpartner 2 verläuft nun in zumindest zwei Schritten. In einem ersten Dekontaktierungsschritt kann eine in Längsrichtung des Gehäuseelements 10 wirkende Zugkraft auf das Gehäuseelement 10 aufgebracht werden, welche von dem Kontaktpartner 2 weg weist. Diese Zugkraft führt dazu, dass sich das Gehäuseelement 10 von dem Kontaktpartner 2 entfernt. Hingegen verbleibt das Kontaktelement 30 jedoch aufgrund der Kontaktkraft bzw. Klemmkraft und der Federlagerung in Kontakt mit dem Kontaktpartner 2. Dadurch wird das Gehäuseelement 10 um eine definierte Länge L₁ gegenüber dem Kontaktelement 30 bei weiterhin bestehendem Kontakt verstellt. Die gezeigte Ausbildung des Federelements 40 führt dazu, dass die Länge L₁ so gewählt werden kann, dass der Abstand zwischen dem eingezogenen Kontaktelement 30 und dessen Kontaktpartner 2 ausreicht, um die Entstehung eines Störlichtbogens auszuschließen oder zumindest die Einwirkzeit eines dennoch entstandenen Störlichtbogens zu reduzieren. Im gezeigten Beispiel beträgt die Länge L₁ 15mm, wobei eine Dekontaktierung erfolgt bevor das als Druckfeder ausgebildete Federelement 40 voll gestaucht ist.

Der zweite Dekontaktierungsschritt beginnt, wenn die auf das Gehäuseelement aufgebrachte Zugkraft und die auf das Kontaktelement 30 aufgebrachte Federkraft die Haltekraft des Kontaktpartners 2 übersteigen. Dann löst sich das Kontaktelement 30 von dem leitenden Bereich 3 des Kontaktpartners 2 und federt schlagartig in Richtung des Gehäuseelements 10 ein. Somit ist eine federbewirkte Beschleunigung des Kontaktelements 30 gegenüber dem Gehäuseelement 10 bei gleichzeitiger sicherer Leitfähigkeit realisiert.

### Bezugszeichen

- 1: Kontaktstift
- 2: Kontaktpartner
- 3: leitender Bereich
- 10: Gehäuseelement
- 11: Stützflansch
- 12: Befestigungselement
- 13: Ringflansch
- 14: Anschlagbereich
- 20: Führungskörper
- 22: Stützflansch
- 23: Stützrampe
- 24: Stirnfläche
- 25: Kragenbereich
- 26: Einschnürbereich
- 27: Laschenbereich
- 28: Klemmlasche
- 29: Spalt
- 30: Kontaktelement
- 31: Ausnehmung
- 32: Außenfläche
- 33: Auflaufschräge
- 34: Stützfußabschnitt
- 35: Verschraubung
- 36: Zwischenraum
- 37: Berührungsschutz
- 38: Stützfläche
- 39: Spannabschnitt
- 40: Federelement
- 41: Einschnürungsabschnitt
- 42: Bodenseite
- 44: Abschnitt
- 46: Kragen
- 60: Kontaktmittel
- 80: Kontaktmittel

- A: Abstand
- L₁: Länge
- L₂: Länge
- GST: Grundstellung
- DST: Dekontaktierungsstellung

## Patentansprüche

1. Kontaktstift (1) zum Kontaktieren eines elektrisch leitenden Bereichs (3) eines Kontaktpartners (2), mit einem Gehäuseelement (10), einem Führungskörper (20), welcher in Längsrichtung des Gehäuseelements (10) beweglich angeordnet und von einem Federelement (40) in Längsrichtung kraftbeaufschlagt ist, und einem als Leiter wirkenden Kontaktelement (30), welches mit dem Führungskörper (20) gegenüber dem Gehäuseelement (10) beweglich ist, so dass es wahlweise zwischen einer eingezogenen Grundstellung (GST) und einer ausgezogenen Dekontaktierungsstellung (DST) verstellbar ist, wobei das Federelement (40) das Kontaktelement (30) in die Grundstellung (GST) vorspannt und derart ausgebildet ist, dass eine Dekontaktierung des Kontaktelements (30) von dem leitenden Bereich (3) des Kontaktpartners (2) mittels federbewirkter Beschleunigung gegenüber dem Gehäuseelement (10) erfolgt, wobei der Kontaktstift (1) ein Kontaktmittel (60, 80) zur Herstellung eines elektrisch leitenden Kontaktes zwischen dem Gehäuseelement (10) und dem Führungskörper (20) und/oder dem Kontaktelement (30) zumindest in der Dekontaktierungsstellung (DST) umfasst, wobei das Kontaktmittel (60, 80) zumindest einen federnd ausgebildeten Federabschnitt aufweist, welcher in Dekontaktierungsstellung (DST) kraftbeaufschlagt an dem Gehäuseelement (10) oder dem Führungskörper (20) anliegt.

2. Kontaktstift (1) nach Anspruch 1, wobei das Kontaktmittel (60, 80) in einem zwischen dem Gehäuseelement (10) und dem Führungskörper (20) und/oder dem Kontaktelement (30) gebildeten Zwischenraum (36) angeordnet ist und/oder zumindest abschnittsweise hülsenartig ausgebildet ist.

3. Kontaktstift (1) nach einem der vorangehenden Ansprüche, wobei die Kraftbeaufschlagung in Längsrichtung des Gehäuseelements (10) und/oder ausschließlich durch das Federelement (40) erfolgt.

4. Kontaktstift (1) nach einem der vorangehenden Ansprüche, wobei der Federabschnitt gebildet ist von einer Klemmlasche (28), wobei das Kontaktmittel (60, 80) vorzugsweise mehrere, weiter bevorzugt acht, zueinander beabstandete und in Längsrichtung des Gehäuseelements (10) verlaufende Klemmlaschen (28) aufweist.

5. Kontaktstift (1) nach einem der vorangehenden Ansprüche, umfassend ein Spannmittel, welches derart ausgebildet ist, dass mit zunehmendem Auszug des Führungskörpers (20) gegenüber dem Gehäuseelement (10) die Kraftbeaufschlagung auf den Federabschnitt steigt.

6. Kontaktstift (1) nach Anspruch 5, wobei das Spannmittel gebildet ist von einer Stützrampe (23) an dem Gehäuseelement (10) oder an dem Führungskörper (20), auf welche bei Auszug des Führungskörpers (20) und/oder des Kontaktelements (30) gegenüber dem Gehäuseelement (10) das Kontaktmittel (60) auflaufen kann und/oder gebildet ist von zumindest einem zu dem Gehäuseelement (10) und/oder zu dem Führungskörper (20) und/oder zu dem Kontaktelement (30) gewölbten Spannabschnitt (39) des Kontaktmittels (80) und/oder gebildet ist von einem in Längsrichtung des Gehäuseelements (10) zumindest abschnittsweise konisch ausgebildeten Führungskörper (20) und/oder Kontaktelement (30).

7. Kontaktstift (1) nach einem der vorangehenden Ansprüche, wobei das Gehäuseelement (10) einen zumindest abschnittsweise umfangsseitig angeordneten Einschnürungsabschnitt (41) aufweist, welcher derart mit dem Kontaktmittel (80) zusammenwirkt, dass er zumindest in der Dekontaktierungsstellung (DST) eine Bewegungsrichtung des Federabschnitts in Richtung zu dem Führungskörper (20) und/oder zu dem Kontaktelement (30) vorgibt.

8. Kontaktstift (1) nach einem der vorangehenden Ansprüche, wobei zumindest das Kontaktmittel (60, 80) derart ausgebildet ist, dass die Kraftbeaufschlagung in Dekontaktierungsstellung (DST) bezogen auf den Auszugsweg des Führungskörpers (20) gegenüber dem Gehäuseelement (10) maximal ist.

9. Kontaktstift (1) nach einem der vorangehenden Ansprüche, wobei das Federelement (40) direkt an einer Stirnfläche (24) des Kontaktmittels (60, 80) anliegt.

10. System, umfassend
zumindest einen in einem Stecker angeordneten Kontaktstift (1) nach einem der vorangehenden Ansprüche und
einen Gegenstecker mit zumindest einem Kontaktpartner (2) zum elektrischen Kontaktieren mit dem Kontaktstift (1).
